# EUROPÄISCHE PATENTSCHRIFT

(11) **EP 0 674 828 B1**
(45) Veröffentlichungstag und Bekanntmachung des Hinweises auf die Patenterteilung: **17.07.1996**
(21) Anmeldenummer: 94901739.6
(22) Anmeldetag: 08.12.1993
(51) Int. Cl.: H05K 7/02, G11C 5/00

(54) **VORRICHTUNG MIT EINEM KUNSTSTOFFTRÄGER ZUR AUFNAHME UND HALTERUNG EINES ELEKTRONISCHEN MODULS**
DEVICE WITH A PLASTIC SUBSTRATE TO ACCEPT AND HOLD AN ELECTRONIC MODULE
DISPOSITIF A SUPPORT PLASTIQUE PERMETTANT DE LOGER ET DE MAINTENIR UN MODULE ELECTRONIQUE

(30) Priorität: 17.12.1992 DE 9217265 U; 17.12.1992 DE 9217302 U
(43) Veröffentlichungstag der Anmeldung: 04.10.1995
(73) Patentinhaber: SIEMENS AKTIENGESELLSCHAFT, 80333 München (DE)
(72) Erfinder: KLEIN, Klaus, D-76287 Rheinstetten (DE); MITTNACHT, Franz, D-76227 Karlsruhe (DE); STARCK, Edgar, F-67500 Haguenau (FR)
(86) Internationale Anmeldenummer: DE9301173
(87) Internationale Veröffentlichungsnummer: WO9414306

(56) Entgegenhaltungen:
- EP-A- 0 429 160
- DE-C- 1 765 575
- Patent Abstracts of Japan, Band 8, Nr 55, P-260, Zusammenfasung von JP, 58- 203687 (CANON K.K.), D
- Patent Abstracts of Japan, Band 13, Nr 135, P-851, Zusammenfasung von JP, 63-302490 (MITSUBISHI ELECTRIC CORP)
- Patent Abstracts of Japan, Band 8, Nr 55, P-260, Zusammenfasung von JP, 58- 203686 (CANON K.K.)
- IBM Technical Disclosure Bulletin, Band 23, No. 5, Oktober 1980, M. I Davis, "SOLID-STATE CARTRIDGE SYSTEM"
- DATAMATION April. 15. 1992 p 55-57 "Tiny PC Cards Pack A Punch" Scott D. Palmer, Figuren Seite 55

## Beschreibung

Die Erfindung betrifft ein elektronisches Modul, insbesondere Speichermodul, das an zwei gegenüberliegenden Seiten jeweils eine Leiste aufweist, und einen Kunststoffträger zur Aufnahme und Halterung des elektronischen Moduls in zu den Leisten korrespondierenden Nuten des Kunststoffträgers auf einer Leiterplatte.

Durch elektronische Module, die in einem Kunststoffträger auf einer Leiterplatte aufgenommen werden, sind Systemkomponenten, wie z. B. Zentralbaugruppen oder Kommunikationsprozessoren von Automatisierungsgeräten, mit einem variablen Speicherausbau realisierbar. Sie können je nach Anforderung der Automatisierungsaufgabe mit einem Speicher unterschiedlicher Größe ausgestattet werden. Dabei müssen von dem elektronischen Modul und dem Kunststoffträger zur Aufnahme des Moduls auf der Leiterplatte die Anforderungen der Industrietauglichkeit erfüllt werden.

Der Erfindung liegt die Aufgabe zugrunde, ein elektronisches Modul, insbesondere Speichermodul, und einen Kunststoffträger zur Aufnahme des elektronischen Moduls auf einer Leiterplatte zu schaffen, die mit einfachen Mitteln eine gute elektromagnetische Verträglichkeit gewährleisten und Potentialverschiebungen zwischen dem elektronischen Modul und seiner Umgebung vermeiden.

Diese Aufgabe wird mit dem neuen elektronischen Modul nach Anspruch 1 bzw. dem Kunststoffträger nach Anspruch 6 gelöst. Vorteilhafte Weiterbildungen des elektronischen Moduls sind in den Unteransprüchen 2 bis 5, des Kunststoffträgers in den Unteransprüchen 7 bis 14 angegeben.

Die Erfindung hat den Vorteil, daß Störströme von der Abdeckung des elektronischen Moduls über eine Blattfeder und eine Fahne an der Blattfeder auf Bezugspotential abgeleitet werden und damit keine elektrostatische Aufladung entstehen kann. Bei entsprechender Auslegung des Kunststoffträgers kann die Ableitung der Störströme auch über den gesamten Leistenbereich des elektronischen Moduls erfolgen.

Bei dem elektronischen Modul wird durch mehrere Kontaktierungsstellen im Umfangsbereich der Abdeckungen eine elektrisch niederohmige Verbindung erreicht. Die spezielle Anordnung der Rastverbindungen zwischen Abdeckungen und Kunststoffrahmen ermöglicht eine einfache Montage der Einzelteile durch Zusammendrücken. Kontaktierungsstellen und Rastverbindungen können in Anzahl und Plazierung entsprechend den Anforderungen der elektromagnetischen Verträglichkeit und der mechanischen Stabilität gewählt werden. Bei unlösbaren Rastverbindungen sind eine hohe Verwindungssteifigkeit und große Biegestabilität des elektronischen Moduls gewährleistet. Wenn eine Abdeckung gewählt wird, die neben der elektrischen Leitfähigkeit auch gut wärmeleitend ist, so ist durch die unmittelbare Nachbarschaft der zu kühlenden Bauelemente auf der Leiterplatte zu den Abdeckungen eine gute Wärmeableitung gegeben. Die erfindungsgemäße Gestaltung der Teile hat den Vorteil, daß die Montage kleberlos und ohne zusätzliche Verbindungselemente möglich ist. Fügehilfen sind einfach realisierbar. Zur Erhöhung der mechanischen Stabilität und zur Vermeidung von Kurzschlüssen können Abstandhalter zwischen Abdeckungen und Leiterplatte eingelegt werden. Zur besseren Handhabung des elektronischen Moduls ist ein Ziehgriff in Rastpunkte an der Vorderseite des Kunststoffrahmens einsetzbar, der bei Bedarf auch wieder einfach entfernt werden kann. An der Vorderseite kann weiterhin ein Fach für eine auswechselbare Pufferbatterie des elektronischen Moduls vorgesehen werden.

Durch den Kunststoffträger mit zwei einander gegenüberliegenden Blattfedern wird eine sichere Kontaktierung der oberen sowie der unteren Abdeckung des elektronischen Moduls erreicht. Zum sicheren Kontakt der Blattfeder mit Bezugspotential kann die Fahne mit einer Lasche versehen werden, die durch den Anpreßdruck von Befestigungselementen des Kunststoffträgers gegen Bezugspotential führende Leitungen auf der Leiterplatte gedrückt wird. Die Anordnung der Blattfeder vorne im Bereich des Schienenanfangs bewirkt, daß beim Stecken des elektronischen Moduls die Verbindung zum Bezugspotential hergestellt wird, bevor Steckverbinder in Kontakt kommen. Dadurch wird eine Zerstörung empfindlicher Bauelemente bei der Montage vermieden. Zur Herstellung einer elektrischen Verbindung mit einer Frontplatte genügt eine relativ kurze, nach vorne geführte Fahne. Durch eine zusätzliche, nach oben auf eine benachbarte Leiterplatte geführte Fahne kann über die Blattfeder des Kunststoffträgers eine Bezugspotentialverbindung zwischen zwei benachbarten Leiterplatten hergestellt werden. Blattfedern können leicht in den Kunststoffträger eingesetzt werden und sind dort unverlierbar angeordnet, wenn das obere Teil, welches die beiden Blattfedern verbindet, in einer schlitzförmigen Ausnehmung des Kunststoffträgers im Joch der Schiene gelagert wird und wenn die Blattfedern an ihren gegenüberliegenden Enden Vorsprünge aufweisen, welche in dazu korrespondierende Ausnehmungen in den Schenkeln hineinragen. Die Blattfedern einschließlich verbindendem Teil und Fahnen sind als einteiliges Bauelement durch Stanzen und Biegen aus Flachmaterial herstellbar. Zur Gewährleistung eines bleibend guten Kontaktes ist es vorteilhaft, das Bauteil galvanisch zu verzinnen. Bei Verwendung eines zweigeteilten Kunststoffträgers ist ein Teil, der darunterliegende Bauelemente auf der Leiterplatte verdeckt, zur Fehlersuche oder Reparatur einfach abnehmbar, auch wenn der Steckverbinder bereits mit der Leiterplatte verlötet ist.

Mit dem erfindungsgemäßen elektronischen Modul und dem Kunststoffträger ist ohne weiteres die Einhaltung der Anforderungen zur Industrietauglichkeit möglich. Eine damit ausgestattete Zentraleinheit eines Automatisierungsgerätes ist durch Austausch der Module erweiterbar und auf einfache Weise an die jeweils gestellte Aufgabe anzupassen.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen:
- Figur 1: eine Explosionszeichnung eines erfindungsgemäßen elektronischen Moduls,
- Figur 2: ein Schnittbild einer Kontaktierungsstelle,
- Figur 3: ein Schnittbild einer Rastverbindung,
- Figur 4: eine Explosionszeichnung eines erfindungsgemäßen Kunststoffträgers,
- Figur 5: Blattfedern mit einer Fahne nach vorne und
- Figur 6: Blattfedern mit einer Fahne nach oben.

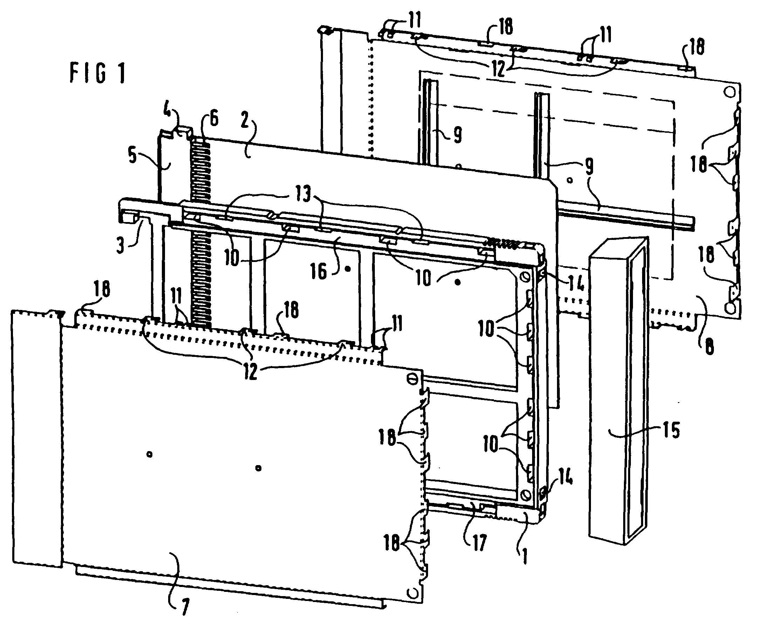

Ein elektronisches Modul besteht nach Figur 1 aus einem Kunststoffrahmen 1, der eine Leiterplatte 2 aufnimmt. Der Kunststoffrahmen 1 weist eine Aussparung 3 auf, in die ein Zapfen 4 des Steckverbinders 5 auf der Leiterplatte 2 hineinragt, damit die zum Stecken und Ziehen des elektronischen Moduls erforderlichen Kräfte auf den Kunststoffrahmen 1 übertragen und Lötverbindungen 6 des Steckers 5 entlastet werden. Abdeckungen 7 und 8 sind zur Abschirmung des elektronischen Moduls gegen elektromagnetische Einstrahlungen vorgesehen. Zwischen der Leiterplatte 2 und den Abdeckungen 7 bzw. 8 können zur Vermeidung von Kurzschlüssen Abstandhalter 9 eingesetzt werden. Im Umfangsbereich sind in dem Kunststoffrahmen 1 zwischen Ober- und Unterseite durchgehende Ausnehmungen 10 angebracht. Im montierten Zustand des elektronischen Moduls ragen in diese Ausnehmungen 10 Laschen 11 und 18 hinein, die eine elektrische Verbindung zwischen den Abdeckungen 7 und 8 herstellen. Haken 12 greifen in weitere Ausnehmungen 13 ein und bewirken dort eine Rastverbindung. An der Frontseite ist der Kunststoffrahmen 1 mit Rastpunkten 14 versehen, an denen ein Ziehgriff 15 befestigt werden kann. Die beiden Abdeckungen 7 und 8 erstrecken sich bis auf die Leisten 16 und 17 des Kunststoffrahmens 1, so daß über einen Kunststoffträger zur Aufnahme und Halterung des elektronischen Moduls eine Verbindung zu Bezugspotential hergestellt werden kann. Sie sind identisch ausgeführt und daher ohne weiteres vertauschbar.

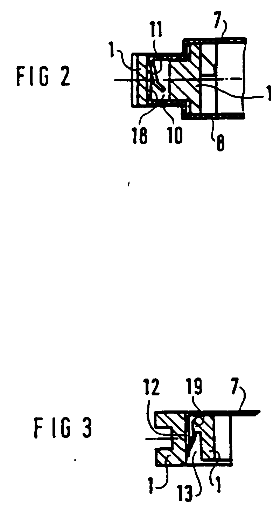

In dem Schnittbild nach Figur 2 ist der Bereich einer Kontaktierungsstelle dargestellt. Laschen 11 der Abdeckung 7 sowie eine Lasche 18 der Abdeckung 8 ragen in eine Ausnehmung 10 des Kunststoffrahmens 1 hinein. Die Laschen 11, die bei der Montage nach innen gebogen werden, liegen aufgrund ihrer Federkraft fest auf der Lasche 18 auf und stellen so einen sicheren Kontakt zwischen den beiden Abdeckungen 7 und 8 her.

Figur 3 zeigt eine Rastverbindung im Steckerbereich des elektronischen Moduls. Ein Haken 12, der in einer Ausnehmung 13 des Kunststoffrahmens 1 zu liegen kommt, hintergreift dort einen Vorsprung 19 und verhakt sich unlösbar. Er ist auf einfache Weise als Ausklinkung in einem rechtwinklig abgebogenen Fortsatz des Bleches der Abdeckung 7 herstellbar. Mit Hilfe einer derartigen Rastverbindung wird eine hohe Verwindungssteifigkeit des elektronischen Moduls erreicht.

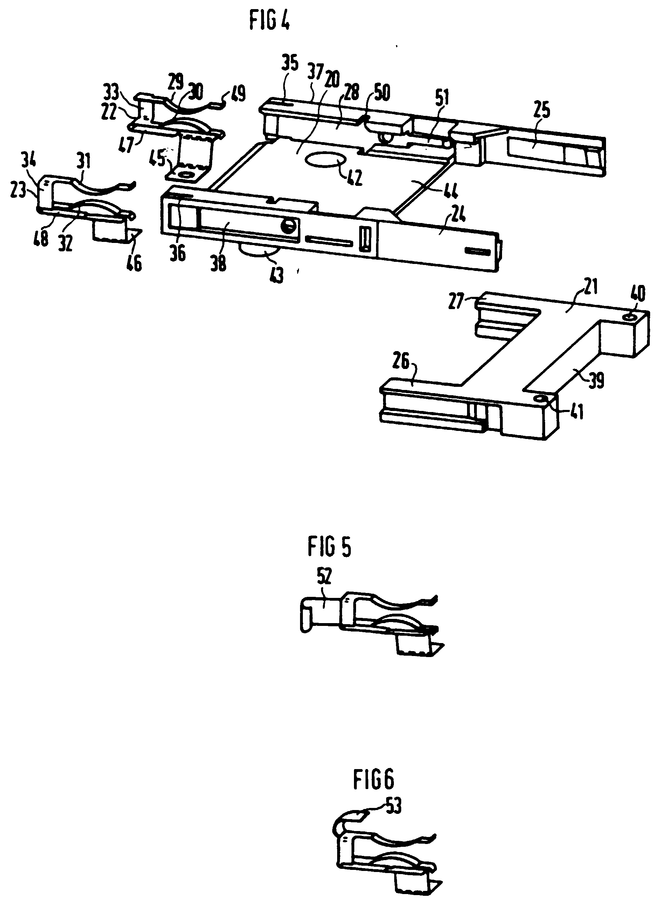

Ein Kunststoffträger besteht nach Figur 4 aus einem Schienenanfangsteil 20, einem Schienenendeteil 21 sowie Kontaktelementen 22 und 23. Zur Montage wird das Schienenanfangsteil 20 mit seinen beiden Armen 24 und 25 über die beiden Schienen 26 und 27 des Schienenendeteils 21 geschoben, so daß die beiden Teile 20 und 21 eine Rastverbindung eingehen, die durch Spreizen der Arme 24 und 25 wieder gelöst werden kann. Weiterhin werden die Kontaktelemente 22 und 23 in Nuten des Schienenanfangsteils 20 eingefügt, von denen in der perspektivischen Darstellung nur die Nut 28 sichtbar ist. Die beiden Kontaktelemente 22 und 23, die jeweils Blattfedern 29 und 30 bzw. 31 und 32 aufweisen, kommen mit ihren die Blattfedern verbindenden Teilen 33 und 34 jeweils in schlitzförmigen Ausnehmungen 35 und 36 in den Jochen 37 und 38 der U-förmigen Schienen zu liegen. Die Blattfedern 29, 30, 31 und 32 sind aufgrund ihrer Ausbildung mit einer Wölbung im mittleren Bereich weitgehend sicher gegen Beschädigungen beim Stecken oder Ziehen eines Moduls. Steckverbinder zur Kontaktierung eines elektronischen Moduls sowie das erfindungsgemäße elektronische Modul selbst und die Leiterplatte, auf welcher der erfindungsgemäße Kunststoffträger befestigt wird, sind der Übersichtlichkeit wegen in Figur 4 nicht dargestellt. Der Steckverbinder wird im Bereich 39 des Schienenendeteils 21 angeordnet. Zur Befestigung auf der Leiterplatte ist der Kunststoffträger mit Bohrungen 40, 41 sowie zwei weiteren aufgrund ihrer Anordnung in Vertiefungen 42 und 43 einer Grundplatte 44 in der Figur 4 nicht sichtbaren Bohrungen versehen. Die Grundplatte 44 wird im montierten Zustand im Bereich der beiden letztgenannten Bohrungen durch zwei Laschen 45 und 46 abgedeckt. Auf diese Weise stellen die Laschen 45 und 46 einen sicheren Kontakt zu Leiterbahnen der Leiterplatte her, die Bezugspotential führen. Über Fahnen 47 und 48 sind sie jeweils mit den Blattfedern verbunden. Die Blattfedern weisen jeweils einen Vorsprung 49 auf, der in eine dazu korrespondierende Ausnehmung 50 eines Schenkels einer U-förmigen Schiene eingreift. Dadurch sind die Blattfedern gegen Verschieben in den Nuten gesichert. Zwei Arretierfedern, von denen nur die eine (51) sichtbar ist, dienen zur rüttelfesten Halterung des elektronischen Moduls in dem Kunststoffträger. Da die Oberseite des Kunststoffträgers offen ist, werden keinerlei einschränkende Bedingungen an die Höhe des elektronischen Moduls gestellt.

Eine Blattfeder nach Figur 5 ist mit einer nach vorne geführten Fahne 52 versehen, die eine elektrische Verbindung zum Bezugspotential einer elektrisch leitenden Frontplatte herstellt.

Eine nach oben geführte Fahne 53 gemäß Figur 6 ermöglicht die elektrische Verbindung zwischen zwei benachbarten Leiterplatten über das Kontaktelement des Kunststoffträgers.

## Patentansprüche

1. Elektronisches Modul, insbesondere Speichermodul, das an zwei gegenüberliegenden Seiten jeweils eine Leiste (16, 17) aufweist zur Aufnahme und Halterung des Moduls in dazu korrespondierenden Nuten (28) zweier U-förmiger Schienen eines Kunststoffträgers, mit einem Kunststoffrahmen (1), der eine bestückte Leiterplatte (2) aufnimmt und der an seiner Ober- und/oder Unterseite eine elektrisch leitende Abdeckung (7, 8) trägt, welche sich bis auf die Leisten (16, 17) erstreckt.

2. Elektronisches Modul nach Anspruch 1, **dadurch gekennzeichnet,**
- daß auf beiden Seiten eine Abdeckung (7, 8) vorhanden ist und
- daß der Kunststoffrahmen (1) im Umfangsbereich Ausnehmungen (10) aufweist, in welche rechtwinklig abgebogene Laschen (11, 18) der beiden Abdeckungen (7, 8) hineinragen und eine elektrische Verbindung zwischen den Abdeckungen (7, 8) herstellen.

3. Elektronisches Modul nach Anspruch 1 oder 2, **dadurch gekennzeichnet**,
- daß der Kunststoffrahmen (1) im Umfangsbereich weitere Ausnehmungen (13) aufweist, die derart ausgebildet sind, daß sie mit hineinragenden Haken (12) der Abdeckungen (7, 8) eine Rastverbindung eingehen.

4. Elektronisches Modul nach Anspruch 3, **dadurch gekennzeichnet,**
- daß die Rastverbindung unlösbar ist.

5. Elektronisches Modul nach einem der Ansprüche 2 bis 4, **dadurch gekennzeichnet**,
- daß die beiden Abdeckungen (7, 8) identisch sind.

6. Kunststoffträger zur Aufnahme und Halterung eines elektronischen Moduls nach einem der Ansprüche 1 bis 5, **dadurch gekennzeichnet,**
- daß eine elektrisch leitende Blattfeder (29, 30, 31, 32) innen auf einem Schenkel mindestens einer U-förmigen Schiene des Kunststoffträgers angeordnet ist zur Kontaktierung der Abdeckung (7, 8) des Moduls im Bereich der Leiste (16, 17), die mit mindestens einer Fahne (47, 48) zur elektrischen Verbindung mit einem Bezugspotential versehen ist.

7. Kunststoffträger nach Anspruch 6, **dadurch gekennzeichnet,**
- daß die Blattfeder (29 ... 32) im wesentlichen parallel zur Schiene verläuft, mit ihren beiden Enden auf der Innenseite des Schenkels aufliegt und sich mit einer Wölbung im mittleren Bereich an die Abdeckung anlegt.

8. Kunststoffträger nach Anspruch 6 oder 7, **dadurch gekennzeichnet,**
- daß auf den Innenseiten der Schenkel einer U-förmigen Schiene (37, 38) einander gegenüberliegend zwei Blattfedern (29, 30; 31, 32) angeordnet sind, die an mindestens einem Ende durch ein das Joch der Nut in der U-förmigen Schiene übergreifendes Teil (33, 34) miteinander verbunden sind.

9. Kunststoffträger nach einem der Ansprüche 6 bis 8, **da-durch gekennzeichnet,**
- daß eine Fahne (47, 48) als Fortsatz am Ende einer Blattfeder (30, 32) ausgebildet ist, der um 180° gebogen an der Außenseite des Schenkels zurückgeführt und mit einer Lasche (45, 46) versehen ist, die eine Grundplatte (44) des Kunststoffträgers im Bereich einer Bohrung zur Befestigung auf einer weiteren Leiterplatte abdeckt.

10. Kunststoffträger nach einem der Ansprüche 6 bis 9, **dadurch gekennzeichnet**,
- daß die Blattfeder (29, 30, 31, 32) vorne im Bereich des Schienenanfangs angeordnet ist und eine Fahne (52) nach vorne geführt ist zur elektrischen Verbindung mit einer Frontplatte.

11. Kunststoffträger nach einem der Ansprüche 6 bis 10, **dadurch gekennzeichnet,**
- daß eine Fahne (53) nach oben auf die der weiteren Leiterplatte gegenüberliegende Seite geführt ist zur elektrischen Verbindung mit einer benachbarten Leiterplatte.

12. Kunststoffträger nach einem der Ansprüche 8 bis 11, **dadurch gekennzeichnet,**
- daß das Teil (33, 34), welches die beiden Blattfedern (29, 30; 31, 32) verbindet, in einer schlitzförmigen Ausnehmung (35, 36) im Joch der Schiene gelagert ist und
- daß die beiden Blattfedern (29, 30; 31, 32) an ihren gegenüberliegenden Enden Vorsprünge (49) aufweisen, welche in dazu korrespondierende Ausnehmungen (50) in den Schenkeln hineinragen.

13. Kunststoffträger nach einem der Ansprüche 6 bis 12, **dadurch gekennzeichnet,**
- daß die Blattfeder (29, 30, 31, 32) galvanisch verzinnt ist.

14. Kunststoffträger nach einem der Ansprüche 6 bis 13, **dadurch gekennzeichnet,**
- daß die Schienen (26, 38; 27, 37) zweigeteilt sind und
- daß das Schienenanfangsteil (20) in dem Schienenendeteil (21), das einen Steckverbinder für das elektronische Modul aufweist, durch eine lösbare Rastverbindung befestigt ist.

## Claims

1. An electronic module, more particularly a storage module, which on two opposite sides comprises a strip (16, 17) for receiving and holding the module in corresponding grooves (28) of two U-shaped rails of a plastics material substrate, with a plastics material frame (1), which receives a fitted circuit board (2) and which on its upper and/or lower sides carries an electrically conductive cover (7, 8), which extends as far as the strips (16, 17).

2. An electronic module according to claim 1, characterised in that a cover (7, 8) is provided on both sides, and the plastics material frame (1) comprises recesses (10) in the circumferential region, into which tongues (11, 18) of the covers (7, 8) bent at right angles project and form an electrical connection between the covers (7, 8).

3. An electronic module according to claim 1 or 2, characterised in that the plastics material frame (1) comprises further recesses (13) in the circumferential region, which are constructed in such a manner that they form a catch connection with hooks (12) of the covers (7, 8), which project into the recesses (13).

4. An electronic module according to claim 3, characterised in that the catch connection is non-releasable.

5. An electronic module according to one of claims 2 to 4, characterised in that the two covers (7, 8) are identical.

6. A plastics material substrate for receiving and holding an electronic module according to one of claims 1 to 5, characterised in that an electrically conductive leaf spring (29, 30, 31, 32) is arranged on the inside of a limb of at least one U-shaped rail of the plastics material substrate for contacting the cover (7, 8) of the module in the region of the strip (16, 17), which leaf spring is provided with at least one lug (47, 48) for electrical connection with a reference potential.

7. A plastics material substrate according to claim 6, characterised in that the leaf spring (29.....32) extends substantially parallel to the rail, rests with its two ends against the inside of the limb and with a curvature in the central region against the cover.

8. A plastics material substrate according to claim 6, or 7, characterised in that two leaf springs (29, 30; 31, 32) are arranged opposite one another on the inside of a limb of a U-shaped rail (37, 38), the leaf springs being connected to one another at least at one end by means of a section (33, 34), which engages over the yoke of the groove in the U-shaped rail.

9. A plastics material substrate according to one of claims 6 to 8, characterised in that a lug (47, 48) is constructed as an extension on the end of a leaf spring (30, 32), which is bent backwards through 180º on the outside of the limb and is provided with a tongue (45, 46), which covers a base plate (44) of the plastics material substrate in the region of a bore for securing to a further circuit board.

10. A plastics material substrate according to one of claims 6 to 9, characterised in that the leaf spring (29, 30, 31, 32) is arranged at the front in the region of the rail start and a lug (52) is bent forwards for electrical connection with a front plate.

11. A plastics material substrate according to one of claims 6 to 10, characterised in that a lug (53) is bent upwards onto the side opposite the further circuit board for electrical connection with an adjacent circuit board.

12. A plastics material substrate according to one of claims 8 to 11, characterised in that the section (33, 34) which connects the two leaf springs (29, 30; 31, 32) is mounted in a slot-like recess (35, 36) in the yoke of the rail and the two leaf springs (29, 30; 31, 32) comprise projections (49) at their opposite ends, which projections project into corresponding recesses (50) in the limbs.

13. A plastics material substrate according to one of claims 6 to 12, characterised in that the leaf spring (29, 30, 31, 32) is galvanised with tin.

14. A plastics material substrate according to one of claims 6 to 13, characterised in that the rails (26, 38; 27, 37) are divided into two parts and the rail start section (20) is secured by a releasable catch connection in the rail end section (21), which comprises a plug connector for the electronic module.

## Revendications

1. Module électronique, notamment module de mémoire, qui comporte sur deux côtés opposés respectivement une baguette (16,17) destinée à la réception et au maintien du module dans des rainures (28) correspondantes de deux rails en forme de U d'un support en matière plastique, qui comporte un cadre (1) en matière plastique, qui reçoit une plaquette (2) à circuits imprimés équipée et qui porte sur sa face supérieure et/ou sa face inférieure un écran (7,8) conducteur de l'électricité, lequel s'étend jusqu'aux baguettes (16,17).

2. Module électronique suivant la revendication 1, caractérisé en ce que
- un écran (7,8) est prévu des deux côtés et
- le cadre (1) en matière plastique comporte, dans la région du pourtour, des logements (10), dans lesquels pénètrent des languettes (11,18) coudées à angle droit des deux écrans (7,8) en créant une liaison électrique entre les écrans (7,8).

3. Module suivant la revendication 1 ou 2, caractérisé en ce que
- le cadre (1) en matière plastique comporte, dans la région du pourtour, des logements (13) supplémentaires conformés de manière à s'encliqueter avec des crochets (12) des écrans (7,8) qui y pénètrent.

4. Module suivant la revendication 3, caractérisé en ce que l'encliquetage ne peut pas se désencliqueter.

5. Module suivant l'une des revendications 2 à 4, caractérisé en ce que les deux écrans (7,8) sont identiques.

6. Support en matière plastique destiné à recevoir et à supporter un module électronique suivant l'une des revendications 1 à 5, caractérisé en ce que
- un ressort (29,30,31,32) à lame conducteur de l'électricité est disposé à l'intérieur sur une branche d'au moins un rail en forme de U du support en matière plastique pour être en contact avec l'écran (7,8) du module dans la région de la baguette (16,17), qui est munie d'au moins un talon (47,48) pour la liaison électrique à un potentiel de référence.

7. Support en matière plastique suivant la revendication 6, caractérisé en ce que
- le ressort (29...32) à lame s'étend sensiblement parallèlement au rail, s'applique par ses deux extrémités au côté intérieur de la branche et touche l'écran par une courbure au milieu.

8. Support en matière plastique suivant la revendication 6 ou 7, caractérisé en ce que
- deux ressorts (29,30,31,32) à lame sont disposés opposés l'un à l'autre sur les côtés intérieurs des branches d'un rail (37,38) en forme de U, ces ressorts étant reliés l'un à l'autre à au moins une extrémité par une partie (33,34) qui agrippe la travée de la gorge du rail en forme de U.

9. Support en matière plastique suivant l'une des revendications 6 à 8, caractérisé en ce que
- un talon (47,48) est formé en tant que prolongement à l'extrémité d'un ressort (30,32) à lame, qui est ramené en le courbant à 180° du côté extérieur de la branche et qui est muni d'une languette (45,46), qui recouvre une plaque (44) de base du support en matière plastique dans la région d'un trou pour la fixation sur une plaquette à circuits imprimés supplémentaire.

10. Support en matière plastique suivant l'une des revendications 6 à 9, caractérisé en ce que
- le ressort (29,30,31,32) à lame est disposé en avant dans la région du début du rail et un talon va vers l'avant pour une liaison électrique avec une plaque frontale.

11. Support en matière plastique suivant l'une des revendications 6 à 10, caractérisé en ce que
- un talon (53) est guidé vers le haut du côté opposé à la plaquette à circuits imprimés supplémentaire pour une liaison électrique avec une plaquette à circuits imprimés voisine.

12. Support en matière plastique suivant l'une des revendications 8 à 11, caractérisé en ce que
- la partie (33,34), qui relie les deux ressorts (29,30,31, 32) à lame, est montée dans un évidement en forme de fente de la travée du rail et en ce que
- les deux ressorts (29,30,31,32) à lame comportent des saillies (49) à leurs extrémités opposées mutuellement, qui pénètrent dans des évidements (50) correspondants des branches.

13. Support en matière plastique suivant l'une des revendications 6 à 12, caractérisé en ce que
- les ressorts (29,30,31,32) à lame sont étamés galvaniquement.

14. Support en matière plastique suivant l'une des revendications 6 à 13, caractérisé en ce que
- les rails (26,38,27,37) sont divisés en deux et en ce que
- la partie (20) de début de rail est fixée par une liaison par encliquetage pouvant se désencliqueter à la partie (21) d'extrémité de rail, qui comporte un connecteur à fiche pour le module électronique.
